# DEMANDE DE BREVET EUROPEEN

(11) **EP 1 324 394 A1**
(43) Date de publication de la demande: **02.07.2003**
(21) Numéro de dépôt: 02354198.0
(22) Date de dépôt: 27.12.2002
(51) Int. Cl.: H01L 29/747, H01L 29/74, H01L 27/08

(54) **Commutateur statique bidirectionnel sensible dans les quadrants Q4 et Q1**

(30) Priorité: 28.12.2001 FR 0117040
(71) Demandeur: STMicroelectronics S.A., 92120 Montrouge (FR)
(72) Inventeur: Ladiray, Olivier, 37270 Montlouis sur Loire (FR)
(74) Mandataire: de Beaumont, Michel

(57) **Abrégé**

L'invention concerne un commutateur bidirectionnel formé dans un substrat semiconducteur (1) de type N, comprenant, dans une première zone, un premier thyristor vertical (Th1) adjacent à un deuxième thyristor vertical (Th2) ; une zone d'amorçage disposée du côté de la face avant, à l'écart de la première zone, comprenant un caisson (11) de type P dans lequel est formée une région (12) de type N ; une première métallisation (M1) recouvrant la face arrière ; une deuxième métallisation (M2) sur les couches de face avant des premier et deuxième thyristors ; une troisième métallisation (M3), de gâchette, sur ledit caisson (11) ; du côté de la face arrière, une région supplémentaire (20) de type P et une couche isolante (21) interposée entre cette région supplémentaire et la première métallisation (M1), la région supplémentaire s'étendant sous la zone d'amorçage ; et une quatrième métallisation (M4) sur ladite région (12).

## Description

La présente invention concerne la réalisation sous forme monolithique de commutateurs bidirectionnels de moyenne puissance.

Les commutateurs bidirectionnels statiques les plus courants sont les triacs. Un triac correspond à l'association en antiparallèle de deux thyristors. Il peut donc être connecté directement dans un réseau alternatif, par exemple le secteur. La gâchette d'un triac classique correspond à la gâchette de cathode de l'un au moins des deux thyristors qui le constituent et est référencée à l'électrode située sur la face avant de ce triac, c'est-à-dire la face qui comporte la borne de gâchette, alors que c'est la face arrière du triac, à la tension haute, qui est couramment reliée à un radiateur, ce qui pose des problèmes d'isolement.

La demande de brevet européen EP-A-0817277 (B2069) décrit un nouveau type de commutateur bidirectionnel dont le déclenchement est assuré par application d'une tension entre une électrode de commande située sur la face avant du composant et une électrode au potentiel de l'électrode principale située sur la face opposée ou face arrière du composant, constituée d'une métallisation recouvrant toute cette face arrière qui peut être connectée à la masse.

La demande de brevet européen EP-A-1076355 (B4341) décrit une amélioration du commutateur ci-dessus permettant d'obtenir une sensibilité relativement élevée à la commande dans les quadrants Q3 et Q2, c'est-à-dire quand la gâchette est susceptible de recevoir une tension de commande négative par rapport à l'électrode de face arrière.

La présente invention vise à proposer une amélioration au composant de la demande de brevet européen EP-A-0817277 permettant d'obtenir une sensibilité relativement élevée à la commande dans les quadrants Q4 et Q1, c'est-à-dire quand la gâchette est susceptible de recevoir une tension de commande positive par rapport à l'électrode de face arrière couramment connectée à la masse et que l'électrode de face avant est respectivement négative et positive par rapport à l'électrode de face arrière.

Pour atteindre cet objet, la présente invention prévoit un commutateur bidirectionnel monolithique formé dans un substrat semiconducteur d'un premier type de conductivité ayant une face avant et une face arrière, comprenant, dans une première zone, un premier thyristor vertical principal dont la couche de face arrière est du deuxième type de conductivité, adjacent à un deuxième thyristor vertical principal dont la couche de face arrière est du premier type de conductivité ; une zone d'amorçage disposée du côté de la face avant, à l'écart de la première zone, cette zone d'amorçage comprenant un caisson du deuxième type de conductivité dans lequel est formée une région du premier type de conductivité ; une première métallisation, d'électrode principale, recouvrant la face arrière ; une deuxième métallisation, d'électrode principale, sur les couches de face avant des premier et deuxième thyristors ; une troisième métallisation, de gâchette, sur ledit caisson ; et, du côté de la face arrière, une région supplémentaire du deuxième type de conductivité et une couche isolante interposée entre cette région supplémentaire et la première métallisation de face arrière, ladite région supplémentaire s'étendant sous la zone d'amorçage et partiellement sous la première zone ; et une quatrième métallisation sur ladite région.

Selon un mode de réalisation de la présente invention, le commutateur bidirectionnel comprend un mur périphérique du deuxième type de conductivité s'étendant de la face arrière à la face avant.

Selon un mode de réalisation de la présente invention, en fonctionnement, la quatrième métallisation est connectée au potentiel de la métallisation de face arrière.

Selon un mode de réalisation de la présente invention, ledit caisson fait en vue de dessus le tour de la première zone, ladite région s'étendant d'un côté seulement de la première zone, du côté du premier thyristor.

Selon un mode de réalisation de la présente invention, à la périphérie de la première zone est disposée une couche faiblement dopée du deuxième type de conductivité séparée du reste de la structure par une zone suffisamment large du substrat pour supporter la tension de claquage visée du composant, cette zone suffisamment large étant séparée en deux parties par un anneau d'arrêt de canal.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un mode de réalisation d'un commutateur bidirectionnel selon un aspect de la présente invention ;
la figure 2 est une vue en coupe schématique d'un mode de réalisation d'un commutateur bidirectionnel selon la présente invention ; et
la figure 3 illustre une caractéristique de courant de déclenchement du commutateur bidirectionnel selon la présente invention.

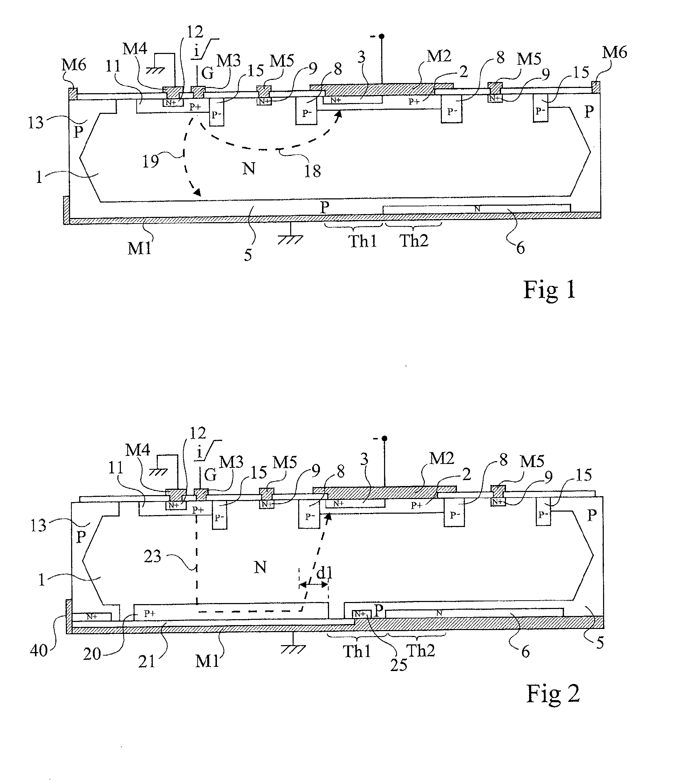

Par souci de clarté, les mêmes éléments ont été désignés par les mêmes références aux différentes figures. De plus, comme cela est habituel dans la représentation des circuits intégrés, les figures 1 et 2 ne sont pas tracées à l'échelle.

La figure 1 est une vue en coupe schématique d'un mode de réalisation d'un commutateur bidirectionnel monolithique selon la présente invention. Le composant comprend essentiellement une structure de commutation de moyenne puissance apte à avoir une tension de claquage élevée, par exemple de 300 à 1000 volts. Contrairement à ce qui représenté en figure 1 par souci de clarté, cette structure de commutation occupe en fait la plus grande partie de la surface du composant. La structure de commutation comprend deux thyristors Th1 et Th2 en anti-parallèle. Le composant est formé dans un substrat semiconducteur 1 de type N. Du côté de la face avant est formé un caisson 2 de type P dans lequel est formée une région 3 de type N. Du côté de la face arrière est formée une couche 5 de type P dans laquelle est formée une région 6 de type N, au moins en regard de la partie du caisson 2 non occupée par la couche 3. Le thyristor Th1 correspond aux régions et couches 5-1-2-3 et a son anode du côté de la face arrière. Le deuxième thyristor Th2 est constitué des régions et couches 6-5-1-2 et a son anode du côté de la face avant.

Du côté de la face avant, la structure de commutation Th1, Th2 est entourée d'une région périphérique destinée à assurer la tenue en tension. Cette région périphérique comprend par exemple un anneau 8 faiblement dopé de type P à la périphérie du caisson 2, séparé latéralement des autres éléments de la structure par une région du substrat N au milieu de laquelle est formé un anneau d'arrêt de canal 9 de type N.

La structure de déclenchement est constituée d'un caisson 11 de type P dans lequel est formée une région 12 de type N⁺. La périphérie du composant est délimitée par un mur 13 de type P qui s'étend de la face arrière à la face avant. On a également représenté pour parfaire la tenue en tension de la partie de commutation un anneau 15 de type P- qui, du côté droit de la figure, constitue la limite du mur 13 et, du côté gauche de la figure, constitue la limite du caisson 11 de type P. Le caisson 11 est séparé du mur 13 d'une distance suffisante pour tenir la tension. A titre de variante non représentée, pour éviter des déclenchements parasites et désensibiliser le thyristor latéral 2-1-11-12, il est prévu une résistance entre le caisson 11 et le mur 13. Cette résistance peut par exemple être réalisée par une région faiblement dopée de type P (P⁻) entre le caisson 11 et le mur 13.

L'ensemble de la face arrière du composant est revêtu d'une métallisation M1, comme cela est classique dans le domaine des composants de moyenne puissance ou de puissance. Une métallisation M2 recouvre l'anode du thyristor Th2 et la cathode du thyristor Th1. Une métallisation de gâchette M3, reliée à une borne de gâchette G est formée sur le caisson P 11 et une métallisation M4 est formée sur la région N⁺ 12. De préférence, une métallisation annulaire M5 revêt la région annulaire 9 et une métallisation annulaire M6 revêt la périphérie du mur 13. Les métallisations M5 et M6 ne sont pas connectées à des bornes extérieures et sont uniquement destinées à assurer l'équipotentialité des régions dopées sous-jacentes.

Le commutateur bidirectionnel selon l'invention est destiné à être déclenché par la mise à un potentiel positif de la borne de gâchette G tandis que la métallisation M4 est reliée à la masse, comme la métallisation M1. Ce mode de déclenchement constitue l'un des aspects de la présente invention.

Dans le quadrant Q4, c'est-à-dire quand la métallisation M2 est négative par rapport à la métallisation M1 qui est reliée à la masse et qu'une tension positive est appliquée à la borne de gâchette, un courant de gâchette circule par la jonction entre le caisson P 11 et la région de gâchette N⁺ 12 qui est polarisée en direct. Des électrons sont alors injectés dans le substrat par diffusion et ils retournent vers la métallisation de gâchette G qui est au potentiel le plus positif. Depuis la région de gâchette G 11, des trous sont injectés dans le substrat. Ces trous sont alors attirés par les potentiels les plus négatifs existant dans la structure. Le potentiel le plus négatif est le potentiel sur la métallisation M2. Ainsi, les trous (flèche 18) tendent à débloquer la jonction entre le substrat 1 de type N et le caisson 2 de type P et le thyristor Th1 tend à devenir passant. Toutefois, étant donné que la métallisation M1, à la masse, est plus négative que le potentiel de la région de gâchette, une partie des trous (flèche 19) se dirigera vers cette métallisation au niveau de laquelle ils se recombineront et ces trous sont perdus pour le déclenchement. Il en résulte qu'il faut prévoir un courant de gâchette important pour pouvoir déclencher le thyristor.

Le trajet que doivent parcourir les trous pour atteindre la zone de déclenchement du thyristor Th1 (flèche 18) est relativement long, étant donné qu'il faut prévoir une zone libre à la périphérie de la structure de commutation proprement dite, afin d'assurer une tension de claquage suffisante. Ainsi, dans le cas où il existe une région N⁺ (non représentée) du côté de la face arrière en regard de la zone de déclenchement, de façon similaire à ce qui a été décrit dans la demande de brevet européen 1076365 susmentionnée, on a constaté qu'il fallait un courant de gâchette supérieur à 40 milliampères pour déclencher le thyristor Th1 dans le quadrant Q4.

Comme le représente la figure 2, pour améliorer la sensibilité de déclenchement, la présente invention propose, en plus de la structure particulière de déclenchement illustrée en figure 1, de disposer sous la zone de déclenchement une région 20 fortement dopée de type P et isolée de la métallisation M1 par une couche isolante 21, de préférence une couche d'oxyde. Avec une telle structure, lors du déclenchement, les trous mentionnés précédemment suivent le trajet 23 représenté en pointillés et se propagent pratiquement sans recombinaison dans la couche 20 fortement dopée de type P. Pour que la couche 20 soit efficace, il faut qu'elle soit présente non seulement sous la zone de déclenchement, c'est-à-dire sous le caisson 11, mais également qu'elle empiète en partie sous la zone correspondant à la structure de commutation proprement dite. On a indiqué en figure 2 par la référence d1 la distance entre la projection de la partie extérieure de l'anneau de type P 8 et la projection de la limite de la région P 20 sous la structure de commutation proprement dite. Cette distance d1 comprend notamment la largeur de l'anneau 8.

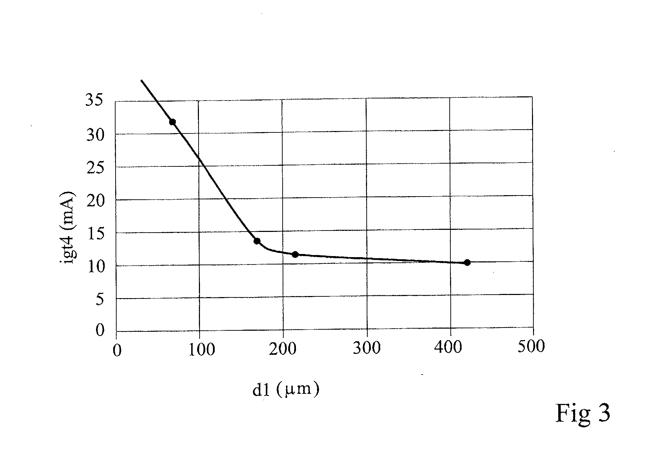

La figure 3 représente la valeur du courant de déclenchement igt4 du thyristor Th1 quand sa cathode est polarisée négativement en fonction de la valeur de la distance d1. On voit que, quand la distance d1 est très faible, le courant de gâchette a une valeur élevée pouvant aller jusqu'à environ 40 mA comme cela a été indiqué précédemment. Dès que la distance d1 devient supérieure à la largeur de l'anneau 8, le courant de déclenchement diminue et arrive sensiblement à un minimum quand la valeur d1 vaut environ 200 µm pour rester ensuite sensiblement constant. La valeur du courant de déclenchement est alors de l'ordre de 10 mA, ce qui est tout à fait acceptable.

On a également représenté en figure 2 une zone métallisée latérale 40 à la périphérie externe du mur d'isolement. Cette zone correspond à une éventuelle remontée de soudure. On notera que, dans le cas illustré, cette remontée de soudure ne présente pas d'inconvénient pour le fonctionnement du circuit. C'est là un autre avantage de la structure selon l'invention.

Bien entendu, le composant selon la présente invention doit également fonctionner de façon satisfaisante quand il est commandé dans le quadrant Q1, c'est-à-dire quand, alors que le courant de gâchette est toujours positif, la métallisation principale M2 est polarisée positivement par rapport à la métallisation principale M1. Dans ce cas, on considère les électrons diffusés dans le substrat à partir de la région N⁺ 12. Ces électrons se propagent sans difficulté dans le substrat de type N vers la métallisation positive M2 pour rendre passante la jonction bloquante entre la couche 3 de type N et le caisson 2. La présence de la couche P⁺ isolée 20 est sans inconvénient sur le fonctionnement de ce mode de déclenchement et produit également l'avantage, relativement secondaire dans ce cas, d'éviter une recombinaison du côté de la métallisation M1.

L'homme de l'art saura apporter diverses améliorations à la structure selon la présente invention pour optimiser son fonctionnement. Par exemple, on mettra de préférence le contact de gâchette M3 le plus près possible de la zone de puissance. A titre d'exemple, si dans la figure 2 on mettait le contact de gâchette sous la métallisation M4 et non pas sous la métallisation M3, on passerait d'un courant de déclenchement de l'ordre de 10 mA à un courant de déclenchement de l'ordre de 25 mA. En effet, dans ce cas la quantité de trous perdus dans le mur d'isolement n'est plus négligeable devant celle qui part dans couche arrière isolée 20.

D'autre part, pour faciliter le déclenchement du thyristor Th1 dans le quadrant Q4, il est préférable que la résistance du caisson 2 de type P sous la région 3 de type N⁺ soit relativement élevée.

Pour assurer la tenue en tension, on prévoira une distance suffisante entre la couche isolée 20 de type P et, d'une part, le mur 13, d'autre part, la couche P 5. On prévoira de préférence une bande dopée de type N 25 à la limite de la couche d'isolement 21 du côté du composant de puissance dans la couche 5 dopée de type P. Ceci évite qu'une partie des trous soit attirée par l'intermédiaire de cette couche P dans la métallisation M1.

Le caisson 11 pourra se prolonger en un anneau recouvert de la métallisation de gâchette M3 entourant toute la zone de puissance.

Bien entendu, la présente invention est susceptible de diverses variantes et modifications qui apparaîtront à l'homme de l'art. En particulier, la présente invention s'applique à tout type de réalisation sous forme monolithique de la structure d'un réseau de commutateurs. En outre, tous les types de conductivité pourraient être inversés, les polarisations étant alors modifiées de façon correspondante. Egalement, pour améliorer la sensibilité des thyristors on pourra de façon usuelle prévoir des trous de court-circuit d'émetteur dans la région N⁺ 3 correspondant à la cathode du thyristor Th1.

## Revendications

1. Commutateur bidirectionnel monolithique formé dans un substrat semiconducteur (1) d'un premier type de conductivité ayant une face avant et une face arrière, comprenant :
dans une première zone, un premier thyristor vertical principal (Th1) dont la couche de face arrière (5) est du deuxième type de conductivité, adjacent à un deuxième thyristor vertical principal (Th2) dont la couche de face arrière (6) est du premier type de conductivité ;
une zone d'amorçage disposée du côté de la face avant, à l'écart de la première zone, cette zone d'amorçage comprenant un caisson (11) du deuxième type de conductivité dans lequel est formée une région (12) du premier type de conductivité ;
une première métallisation (M1), d'électrode principale, recouvrant la face arrière ;
une deuxième métallisation (M2), d'électrode principale, sur les couches de face avant des premier et deuxième thyristors ;
une troisième métallisation (M3), de gâchette, sur ledit caisson (11) ;
**caractérisé en ce qu'**il comporte, du côté de la face arrière, une région supplémentaire (20) du deuxième type de conductivité et une couche isolante (21) interposée entre cette région supplémentaire et la première métallisation (M1) de face arrière, ladite région supplémentaire s'étendant sous la zone d'amorçage et partiellement sous la première zone tout en étant disjointe des couches de face arrière des premier et deuxième thyristors ; et une quatrième métallisation (M4) sur ladite région (12).

2. Commutateur bidirectionnel selon la revendication 1, **caractérisé en ce qu'**il comprend un mur périphérique (13) du deuxième type de conductivité s'étendant de la face arrière à la face avant.

3. Commutateur bidirectionnel selon la revendication 1, **caractérisé en ce que**, en fonctionnement, la quatrième métallisation (M4) est connectée au potentiel de la métallisation de face arrière (M1).

4. Commutateur bidirectionnel selon la revendication 3, **caractérisé en ce que** ledit caisson (11) fait en vue de dessus le tour de la première zone, ladite région (12) s'étendant d'un côté seulement de la première zone, du côté du premier thyristor (Th1).

5. Commutateur bidirectionnel selon la revendication 3, **caractérisé en ce que** à la périphérie de la première zone est disposée une couche (6) faiblement dopée du deuxième type de conductivité séparée du reste de la structure par une zone suffisamment large du substrat pour supporter la tension de claquage visée du composant, cette zone suffisamment large étant séparée en deux parties par un anneau d'arrêt de canal (9).
